# EUROPEAN PATENT APPLICATION

(11) **EP 3 961 406 A1**
(43) Date of publication of application: **02.03.2022**
(21) Application number: 20193284.5
(22) Date of filing: 28.08.2020
(51) Int. Cl.: G06F 11/36, G05B 23/02

(54) **COMPUTER-IMPLEMENTED METHOD AND COMPUTERIZED DEVICE FOR TESTING A TECHNICAL SYSTEM**

(71) Applicant: Siemens Aktiengesellschaft, 80333 München (DE)
(72) Inventor: Rothbauer, Stefan, 86156 Augsburg (DE); Storck, Stephan, 83075 Bad Feilnbach - Au (DE); Zeller, Marc, 81243 München (DE)

(57) **Abstract**

The computer-implemented method for testing a technical system having a plurality of technical components comprises:
providing a safety model modeling a safety relevant functionality of the technical system,
providing a test model including test cases for testing the technical system,
linking elements of the safety model with elements of the test model for enabling a tracing between the test cases of the test model and the safety-relevant functionality of the safety model,
generating test parameters for at least one certain test case of the test cases and/or a new test case for the test model using the safety model linked to the test model, and
testing the technical system using the certain test case and/or the new test case.

Further, a computer program product, a computerized device and and an arrangement having a technical system and a computerized device are suggested.

## Description

The present invention relates to a computer-implemented method and to a computer program product for testing a technical system having a plurality of technical components. The present invention further relates to a computerized device for testing a technical system having a plurality of technical components and to an arrangement comprising a technical system and such a computerized device for testing the technical system.

Testing a technical system may particularly include testing regarding functional behavior of the technical system as well as regarding safety of the technical system.

For example, a technical system to be tested may be a safety-critical system or safety-relevant system. The importance of safety-critical systems in many application domains of embedded systems, such as aerospace, railway, health care, automotive and industrial automation is continuously growing. Thus, along with the growing system complexity, also the need for safety assessment as well as its effort is increasing drastically to guarantee the high-quality demands in these application domains.

A goal of the safety assessment process is to identify all failures that cause hazardous situations and to demonstrate that their probabilities are sufficiently low. In the application domains of safety-critical systems the safety assurance process is defined by the means of safety standards, such as IEC61508 or others.

Traditionally, the analysis of a system in terms of safety consists of bottom-up safety analysis approaches, such as Failure Mode and Effect Analysis (FMEA), and top-down approaches, such as Fault Tree Analysis (FTA) to identify failure modes, their causes, and effects with impact on the system safety. With Component Fault Trees (CFTs) there is a model- and component-based methodology for FTA, which supports a modular and compositional safety analysis strategy.

In particular, for safety-critical systems, there are regulatory requirements to show that the safety-related functions or safety-relevant functionalities perform the intended functionality correctly and that all relevant hazards are dealt by the technical system adequately.

The relevant hazards are captured in safety analyses or safety models, for example. The technical system may then be designed and built to cope with these hazards. However, the safety analyses are usually not connected directly to the system design and test environments. This disconnect between the different engineering disciplines leads to a loss of information, to additional effort required to specify tests or test cases and the check if all measures realized to prevent hazards have been tested.

As technical systems get more complex, a model-based approach is currently being adopted in many parts of the system development. Conventionally, the models for different purposes, like functional behavior testing and safety testing, are created separately by experts. For instance, there is one model for the system architecture of the technical system, one model for testing purposes and one model for safety analysis. Testing and system models have been integrated to some extent to support a partial generation of tests for this technical system from the test models.

However, safety models conventionally consisting of manual analyses performed by safety together with system experts are not integrated with system or test models.

For tests relating to safety analyses, a manual approach has therefore been pursued so far. The safety analyses are looked through by system designers, safety experts and testers to define required tests. This manual approach takes a lot of effort, is limited in scope, as the tests have to be defined manually.

As systems get more and more complex, model-based approaches are used in the system development, but also for testing and safety it is difficult to conventionally evaluate if the defined tests cover the relevant safety functionality adequately.

It is an object of the present invention to enhance the testing of a technical system.

According to a first aspect, a computer-implemented method for testing a technical system having a plurality of technical components is suggested. The computer-implemented method comprises:
a) providing a safety model modeling a safety relevant functionality of the technical system,
b) providing a test model including test cases for testing the technical system,
c) linking elements of the safety model with elements of the test model for enabling a tracing between the test cases of the test model and the safety-relevant functionality of the safety model,
d) generating test parameters for at least one certain test case of the test cases and/or a new test case for the test model using the safety model linked to the test model, and
e) testing the technical system using the certain test case and/or the new test case.

Using the safety model linked to the test model to generate test parameters and/or new test cases increases efficiency and effectiveness of the testing process greatly compared to a conventional, in particular manual approach.

In particular, generating test parameters for test procedures, e.g. combined in a test case, based on the test model can be performed in an automated way advantageously. The common link with the safety model enables to focus test effort adequately on the safety-relevant functionality. Moreover, the tests generated or adapted may directly correspond to cases analyzed in the safety model, in this way verifying system safety requirements.

Furthermore, generating new test cases or test case stubs helps to increase the efficiency of the testing process. Advantageously, manual and repetitive work is reduced. In addition, significantly higher numbers of test cases can be systematically generated, e.g. by parameter variation. A conventional problem with tests is not only the definition of the input values, but also the expected system behavior. This is reflected by the safety model here. In particular, the safety model is created independently, i.e. tests are not created on the basis of just one model and then tested against the values expected according to the same model. That brings additional security and/or trust advantageously.

In particular, depending on the level of information specified within the safety model, or via integration with the test model, an exact way of interaction between different events, the structure of the test cases or test procedures can be generated in more or less detail. Using the present method, the coverage of the proposed test cases with regard to safety analysis can be evaluated.

In other words, based on the safety model linked with the test model, it is advantageously possible to define a suite of required tests for the safety-relevant functionality. For example, if the safety model is given as a Component Fault Tree (CFT), the top event of the CFT allocated to the safety-relevant functionality needs to be verified with adequate tests based on defined coverage targets.

In particular, for each identified test scenario for the safety-relevant functionality, the safety model can then be used to define preconditions for the tests to be executed and relevant triggers for these. In particular, the preconditions for the tests define the relevant context in which the analyzed safety-relevant functionality is expected to ensure a safe behavior of the technical system. These preconditions are linked to corresponding elements of the test model so that the test model is able to use these for test set-up when executing the tests.

For linking the safety model with the test model, a system model may be used, said system model modeling a functional behavior of the technical system. In particular, the system model may be a system architecture model of the technical system.

Particularly, the safety analysis may define the relevant triggers within the test for the safety-relevant functionality to be triggered, which means, all required stimuli that need to be fed into the system after initializing the required context to drive the expected behavior. As in many cases different combinations of triggers are possible, an optimized set of tests to address the combinatorial possibility to trigger a safety-relevant functionality based on defined coverage targets can be created. The combination of possible triggers is described as cut-sets in CFT terminology and can be discovered via an automated analysis approach.

To achieve the above-described link, the test model and the safety model are integrated in a way , in particular via the system model, that allows to map elements of the safety model to relevant technical elements described in the test model that need to be manipulated in order to execute certain tests.

In particular, the test model is an abstraction of the technical system that can be used to drive test design and analysis, in particular having a focus on the functional behavior of the technical system from a given initial state under certain actions and/or events to an expected final state.

In particular, the safety model is adapted to capture causes and reasons that lead to the undesired event of violating the safety-relevant functionality that needs to be prevented, managed or kept quantitatively at a certain level, e.g. the probability of occurrence needs to meet a threshold defined in standards, by regulations or implicitly defined by societal acceptance.

For example, if the safety model consists of a Component Fault Tree (CFT), the safety-relevant functionality that is analyzed is the top event of the CFT. The top event of the CFT is triggered by events occurring together, so-called cut-sets. A cut-set may be a combination of basic events of the CFT and may be adapted to cause said top event. Linking the safety model and the test model captures the connections between the top event to the part of the test model that captures the corresponding functionality that influences the occurrence of the top event. In particular, the elements of the cut-set that trigger the top event are linked to the elements of the test model, e.g. test data, test activities and/or system elements like stimulated interfaces.

In the following, several embodiments for the computer-implemented method for testing a technical system having a plurality of technical components are described.

According to an embodiment, in step d), triggers and parameters of the safety model linked to the test model are analyzed for generating the test parameters for the at least one certain test case and/or the new test case for the test model.

According to a further embodiment, the test parameters generated in step d) include preconditions for the at least one certain test case, said preconditions defining a relevant context for the safety relevant functionality when operating the technical system, and/or relevant triggers within the certain test case for triggering the safety relevant functionality.

According to a further embodiment, in step a), the safety model is provided as a tree of logic, in particular as a Component Fault Tree, such that it includes a top event associated to a violation of the safety-relevant functionality.

For example, if the technical system is a railway and the safety-relevant functionality is decelerating the railway to a certain velocity within a certain time period, then a violation of said safety-relevant functionality may be if the railway cannot be decelerated to said certain velocity within the certain time period.

According to a further embodiment, in step a), the safety model is provided such that it includes, for each of the technical components having an input port and/or an output port,
an output failure mode for modeling a certain failure visible at the output port of the technical component, or
an output failure mode for modeling a certain failure visible at the output port of the technical component and an input failure mode for modeling how a certain failure propagates from the input port to the output port.

According to a further embodiment, in step a), the safety model is provided such that it includes, for each of the technical components having an input port and/or an output port,
an input failure mode for modeling how a certain failure propagates from the input port to the output port,
an output failure mode for modeling a certain failure visible at the output port of the technical component, and/or
a number of basic events, each of the basic events modeling an internal component failure of the technical component.

According to a further embodiment, the safety model includes a number of cut-sets, each of the cut-sets combining a number of basic events and adapted to cause the top event. In particular, the basic events constituting a cut-set are leaves in a Component Fault Tree (CFT) constituting the safety model, for example.

According to a further embodiment, in step c), the top event of the safety model is linked with those elements of the test model capturing a functionality that is configured to influence an occurrence of the top event.

According to a further embodiment, in step c), the safety model and the test model are linked such that
a certain input failure mode of the safety model is linked with a certain input interface of the test model,
a certain output failure mode of the safety model is linked with a certain output interface of the test model,
a certain basic event of the safety model is linked with an internal component state of the test model, and/or
the top event of the safety model is linked with a certain test case of the test cases of the test model.

According to a further embodiment, the method comprises:
providing a system model modeling a functional behavior of the technical system, in particular a system architecture of the technical system, wherein in step c), the safety model and the test model are linked via the system model,
wherein a certain input failure mode of the safety model is linked with a certain input interface of the test model via a certain input port of the system model,
a certain output failure mode of the safety model is linked with a certain output interface of the test model via an output port of the system model,
a certain basic event of the safety model is linked with a certain internal component state of the test model via an internal component failure of the system model, and/or
the top event of the safety model is linked with a test case of the test model via a system function of the system model.

In this embodiment, the safety model and the test model are linked via the system model. Here, the top event of the safety model is mapped to a system function of the system model. This link can be given explicitly or implicitly, e.g. via naming conventions. Moreover, further elements of the safety model that influence such a behavior, such as basic events identified in the safety analysis, are mapped to certain system states or system variables of the system model that can be manipulated, so that the desired behavior is stimulated.

In cases where a default behavior of a technical component is already modeled in the test model, this can be used to generate variations of the behavior covering different fault scenarios. If such default behaviors are not available, simplified fault scenarios are generated based on predefined templates. By analyzing the different triggers and the provided parameters in the safety model, concrete test data for the test cases can then be generated to drive the respective tests. With the generated test scenarios, the generated test data and a test automation framework for the technical system under test, it is advantageously possible to generate a fully automated test suite to cover the safety-relevant functionality or a plurality of safety-relevant functionalities based on defined coverage criteria.

According to a further embodiment, the method comprises:
analyzing the testing for providing coverage criteria for the safety-relevant functionality.

By analyzing the testing based on the test model linked with the safety model, suitable coverage criteria for the safety-relevant functionality of the technical system are provided. By the provided coverage criteria, a quantitative measure is available to determine how well the safety-relevant functionality is covered by the test cases or tests of the test model.

The provided coverage criteria are a suitable test coverage metric that can be evaluated based on the test model and the safety model. In this regard, the linking of the test model and the safety model enables a tracing between the test cases of the test model and the safety relevant functionality of the safety model.

According to a further embodiment, the coverage criteria are provided such that they include probabilistic criteria for each respective test case of the test cases used in step d), said probabilistic criteria indicating a probability of occurrence during operation of the technical system, wherein the probability of occurrence is derived by a probability of the cut-set corresponding to the respective test case via the linking of the test model and the safety model.

In particular, the probabilistic criteria indicate an importance of each test case of the test model. For example, depending on the goals of the testing process using said test model, there may be a focus on very likely cases (high probability), e.g. to ensure that basic functionality is correctly implemented, but also in extremely cases (very low probability) to show that the system is able to deal even with rare cases. For example, different categories for relevant cases may be defined. Moreover, to each of said categories, a suitable approach and coverage target may be defined.

According to a further embodiment, the coverage criteria are provided such that they include qualitative criteria for each respective test case of the test cases used in step e), the qualitative criteria being derived from the number of basic events of the cut-set corresponding to the respective test case via the linking of the test model and the safety model.

In particular, the qualitative criteria may be based on the number of elements of a cut-set. Thus, the importance of each test or test case of the test model may be based on the number of basic events that need to be fulfilled in order to trigger the top event. Here, different classes may be defined, e.g. cases that are triggered with only one event (test all), cases that are triggered by two events (test all combinations, or a certain percentage of these), cases that are triggered by M events, and cases that are triggered by more than M events.

According to a further embodiment, the coverage criteria are provided such that they include criteria of occurrence and/or of probability of occurrence for minimal cut-sets corresponding to the test cases used in step e).

In particular, a cut-set in a logic tree or fault tree is a set of basic events whose (simultaneous) occurrence ensures that the top event occurs. A cut-set is particularly said to be a minimal cut-set if, when any basic event is removed from the cut-set, the remaining events collectively are no longer a cut-set. In particular, for minimal cut-sets, further tests can be derived that ensure that the safety-relevant functionality is not triggered if any one of the required cut-set elements does not evaluate to true.

In particular, the tests or test cases defined in the test model and the link between the test model and the safety model are used to determine test coverage for each safety-relevant functionality with regard to the possibilities given above, i.e. probabilistic criteria or qualitative criteria or both, and if deemed relevant for each defined class within these categories. Based on this information, it becomes apparent which part of the safety-relevant functionality is tested adequately, and where more effort should be spent, or alternatively if testing effort for a certain safety-relevant functionality can be shifted to more efficient testing levels, e.g. from system to integration or software, as the feasible number of system level test cases is far more limited than on lower testing levels.

According to a second aspect, a computer program product is suggested, wherein the computer program product comprises a program code for executing the method of the first aspect or of an embodiment of the first aspect when the program code is run on at least one computer.

A computer program product, such as a computer program means, may be embodied as a memory card, USB stick, CD-ROM, DVD or as a file which may be downloaded from a server in a network. For example, such a file may be provided by transferring the file comprising the computer program product from a wireless communication network.

According to a third aspect, a computerized device for testing a technical system having a plurality of technical components is suggested. The computerized device comprises:
a first providing unit for providing a safety model modeling a safety relevant functionality of the technical system,
a second providing unit for providing a test model including test cases for testing the technical system,
a linking unit for linking elements of the safety model with elements of the test model for enabling a tracing between the test cases of the test model and the safety-relevant functionality of the safety model,
a generating unit for generating test parameters for at least one certain test case of the test cases and/or a new test case for the test model using the safety model linked to the test model, and
a testing unit for testing the technical system using the certain test case and/or the new test case.

In particular, the computerized device may be a computer or workstation. Moreover, the computerized device may be or may include a computer-aided or computer-related system or a computer system.

The respective unit, e.g. first providing unit, the second providing unit, the linking unit, the generating unit and the testing unit, may be implemented in hardware and/or in software. If said unit is implemented in hardware, it may be embodied as a device, e.g. as a computer or as a processor or as a part of a system, e.g. a computer system. If said unit is implemented in software, it may be embodied as a computer program product, as a function, as a routine, as a program code or as an executable object.

The embodiments and features according to the first aspect are also embodiments of the third aspect.

According to a fourth aspect, an arrangement comprising a technical system having a plurality of technical components and a computerized device for testing the technical system according to the third aspect is suggested.

Further possible implementations or alternative solutions of the invention also encompass combinations-that are not explicitly mentioned herein-of features described above or below with regard to the embodiments. The person skilled in the art may also add individual or isolated aspects and features to the most basic form of the invention.

Further embodiments, features, and advantages of the present invention will become apparent from the subsequent description and dependent claims, taken in conjunction with the accompanying drawings, in which:
- Fig. 1: shows a sequence of method steps of an embodiment of a computer-implemented method for testing a technical system;
- Fig. 2: shows an example of a safety model, a system model and a test model for a technical system used by the method of Fig. 1;
- Fig. 3: shows the example of Fig. 2 additionally illustrating a linking of a certain input failure mode of the safety model with a certain input interface of the test model via a certain input port of the system model;
- Fig. 4: shows the example of Fig. 2 additionally illustrating a linking of a certain output failure mode of the safety model with a certain output interface of the test model via an output port of the system model;
- Fig. 5: shows the example of Fig. 2 additionally illustrating a linking of a certain basic event of the safety model with a certain internal component state of the test model via an internal component failure of the system model;
- Fig. 6: shows the example of Fig. 2 additionally illustrating a linking of the top event of the safety model with a test case of the test model via a system function of the system model;
- Fig. 7: shows a schematic block diagram of a computerized device for testing a technical system; and
- Fig. 8: shows a schematic block diagram of an arrangement comprising a technical system and a computerized device for testing a technical system.

In the Figures, like reference numerals designate like or functionally equivalent elements, unless otherwise indicated.

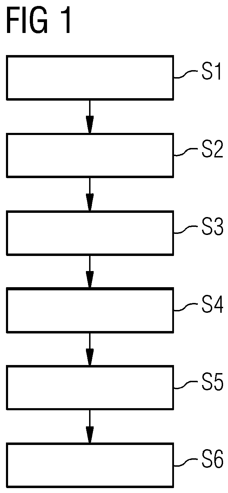

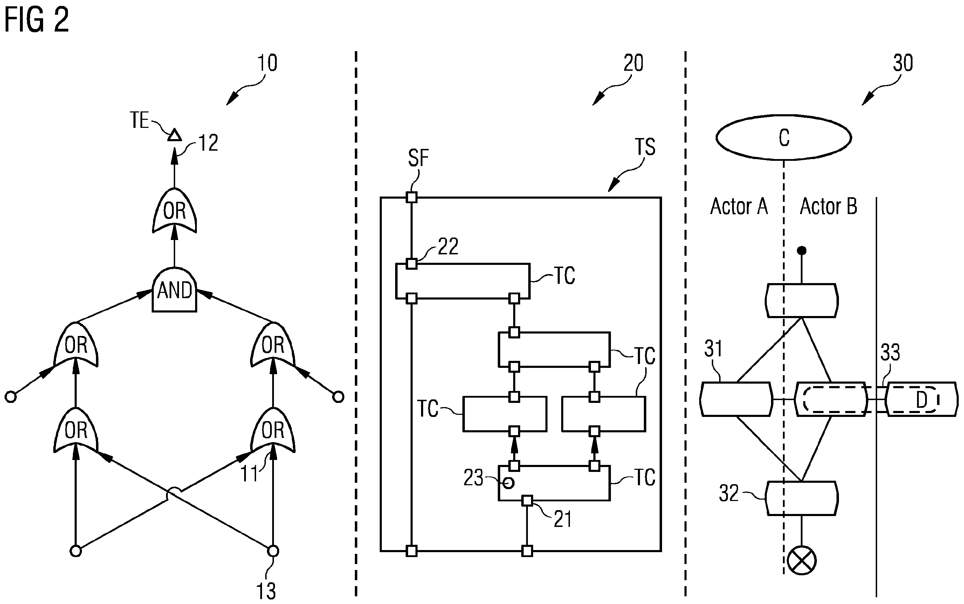

Fig. 1 depicts a sequence of method steps of an embodiment of a computer-implemented method for testing a technical system TS. In Fig. 1, the method steps are designated with S1 - S6. In the following, Fig. 1 is discussed referring to Fig. 2.

In this regard, the left part of Fig. 2 shows an example of a safety model 10 for the technical system TS, the middle part of Fig. 2 shows an example of a system model 20 for the technical system TS and the right part of Fig. 2 shows an example of a test model 30 for the technical system TS.

The technical system TS may be a safety-critical system, for example used in an application domain of embedded systems, such as aerospace, railway, health care, automotive or industrial automation. The technical system TS includes a plurality of technical components TC, for example including actors, sensors and/or receivers.

As indicated above, the method of Fig. 1 includes the method steps S1 - S6: In step S1, a safety model 10 modeling a safety-relevant functionality of the technical system TS is provided. As shown in the left part of Fig. 2, the safety model 10 may be provided as a classic fault tree. Alternatively, the safety model 10 may be provided as a Component Fault Tree. An example for such a Component Fault Tree is shown in the right part of Fig. 1 of the patent application US 2020/0225652 A1.

In particular, the safety model 10 is provided such that it includes a top event TE associated to a violation of the safety-relevant functionality. For example, if the technical system TS is a railway and the safety-relevant functionality is to decelerate the railway to a certain velocity within a certain time period, then a violation of said safety-relevant functionality may be if the railway cannot be decelerated to said certain velocity within the certain time period. This violation is mapped to the top event TE of the safety model 10 of Fig. 2, for example.

The classic fault tree of the safety model 10 of Fig. 2 comprises Boolean formula represented by OR-gates and AND-gates. Further, the classic fault tree of the safety model 10 has a number of input failure modes 11 for modeling how a certain failure propagates from an input port to an output port of a technical component TC of the technical system TS. For illustration issues, only one input failure mode 11 is designated with a reference sign in Fig. 2 to ensure readability.

Furthermore, the classic fault tree of the safety model 10 of Fig. 2 has a number of output failure modes 12, each modeling a certain failure visible at an output port of a technical component TC. Also here, for illustration issues, only one output failure mode 12 is designated with a reference sign in Fig. 2 to ensure readability.

Moreover, the classic fault tree of the safety model 10 of Fig. 2 has a number of basic events 13, each of the basic events 13 modeling an internal component failure of a technical component TC. Also here, for illustration issues, only one basic event 13 is designated with a reference sign in Fig. 2 to ensure readability.

In particular, the safety model 10 includes a number of cut-sets, each of the cut-sets combining a number of basic events 13 and adapted to cause the top event TE.

In step S2, a system model 20 is provided, said system model 20 modeling a functional behavior of the technical system TS. AS shown in the middle part of Fig. 2, the system model 20 may be embodied as a system architecture model of the technical system TS including said plurality of technical components TC.

The system model 20 may include a number of input ports 21, a number of output ports 22 and a number of internal component failures 23. In the middle part of Fig. 2, for illustration issues, only one of the input ports is designated with the reference sign 21, only one of the output ports is designated with the reference sign 22 and only one of the internal component failures is designated with the reference sign 23.

In step S3, a test model 30 is provided, said test model 30 including test cases C for testing the technical system TS. As shown in the right part of Fig. 2, a test case C may include an actor A, an actor B and data D. In this regard, the test case C of the test model 30 has a number of input interfaces 31, a number of output interfaces 32 and a number of internal component states 33.

In step S4, elements of the safety model 10 are linked with elements of the test model 30, in particular using elements of the system model 20, for enabling a tracing between the test cases C of the test model 30 and the safety-relevant functionality of the safety model 10.

In particular, the top even TE of the safety model 10 is linked with those elements of the test model 30 capturing a functionality that is configured to influence an occurrence of the top event TE.

In step S5, test parameters for at least one certain test case C of the test cases and/or a new test case for the test model 30 are generated using the safety model 10 linked to the test model 30.

In particular, in step S5, triggers and parameters of the safety model 10 linked to the test model 30 are analyzed for generating the test parameters for the at least one certain test case C and/or the new test case C for the test model 30.

For example, the test parameters generated in step S5 may include preconditions for the at least one certain test case C. Said preconditions may define a relevant context for the safety relevant functionality when operating the technical system TS, and/or relevant triggers within the certain test case C for triggering the safety relevant functionality.

In step S6, the technical system TS is tested using the certain test case and/or the new test case.

Moreover, the testing may be analyzed for providing coverage criteria for the safety-relevant functionality.

In particular, the coverage criteria are provided such that they include probabilistic criteria for each respective test case of the test cases C. Said probabilistic criteria may indicate a probability of occurrence during operation of the technical system TS, wherein the probability of occurrence may be derived by a probability of the cut-set corresponding the respective test case C via the linking of the test model 30 and the safety model 10.

Further, the coverage criteria may be provided such that they include qualitative criteria for each respective test case C used in step S5. The qualitative criteria may be derived from the number of basic events 13 of the cut-set corresponding to the respective test case C via the linking of the test model 30 and the safety model 10.

As part of the qualitative criteria, a plurality N of different classes for the test case C used in step S5 may be provided, wherein each of said N different classes may be defined by a different number M of basic events 13 configured to cause the top event TE in combination, with M ∈ [1, ..., N].

Additionally, the coverage criteria may be provided such they include criteria of occurrence and/or of probability of occurrence for minimal cut-sets corresponding to the test cases C.

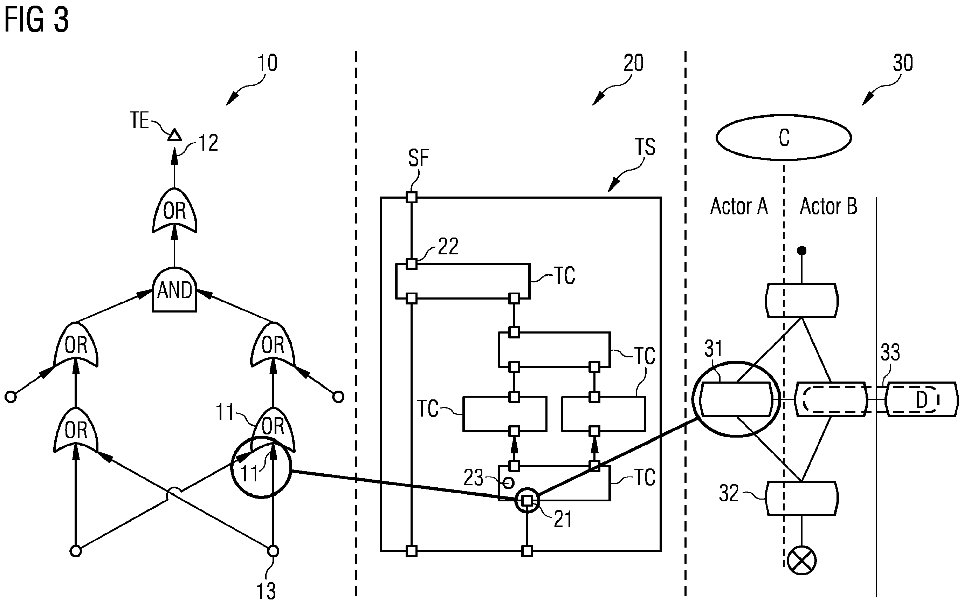

Details and examples for this linking according to step S4 of the safety model 10 and the test model 30 via the system model 20 are shown in Figs. 3 to 6 which are based on the example of Fig. 2. In this regard, Fig. 3 additionally illustrates a linking of a certain input failure mode 11 of the safety model 10 with a certain input interface 31 of the test model 30 via a certain input port 21 of the system model 20.

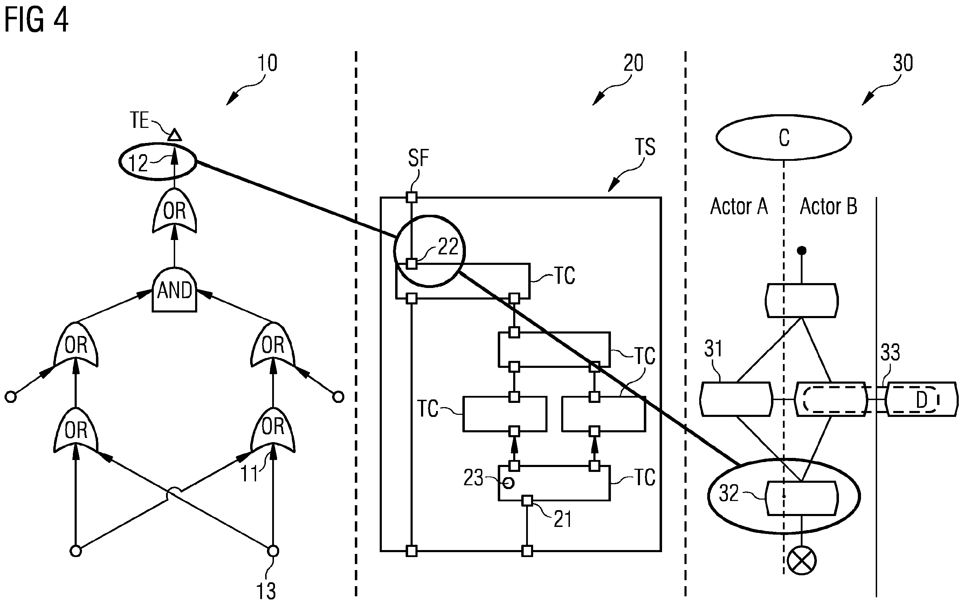

Moreover, Fig. 4 additionally illustrates a linking of a certain output failure mode 12 of the safety model 10 with a certain output interface 32 of the test model 30 via an output port 22 of the system model 20.

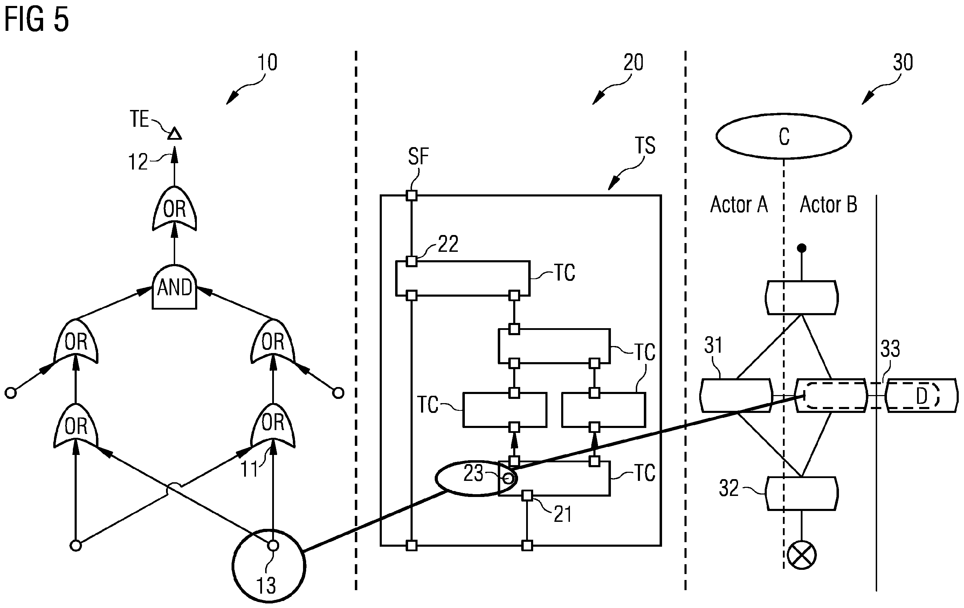

Furthermore, Fig. 5 additionally illustrates a linking of a certain basic event 13 of the safety model 10 with a certain internal component state 33 of the test model 30 via an internal component failure 23 of the test model 20.

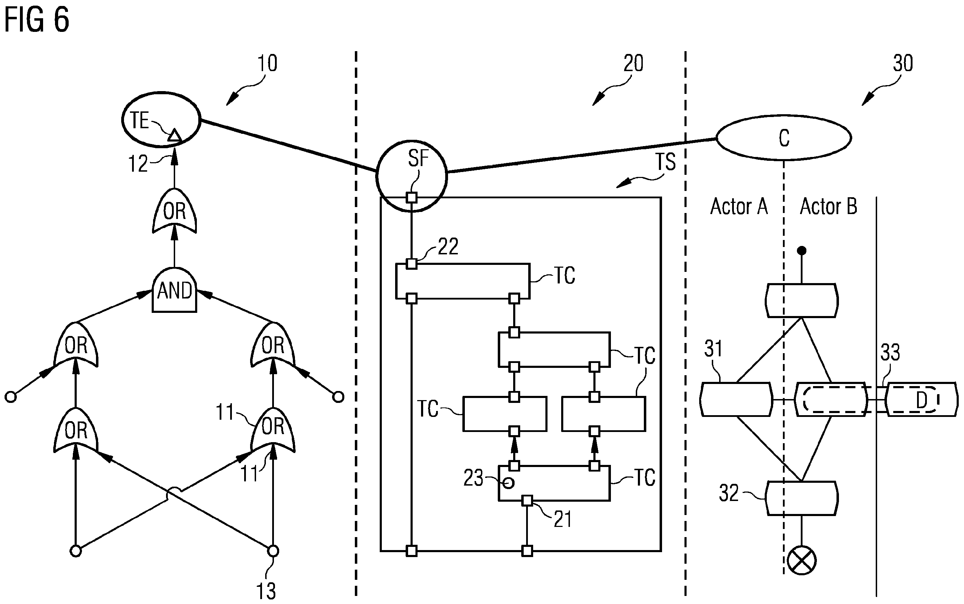

Moreover, Fig. 6 additionally shows a linking of the top event TE of the safety model 10 with a test case C of the test model 30 via a system function SF of the system model 20.

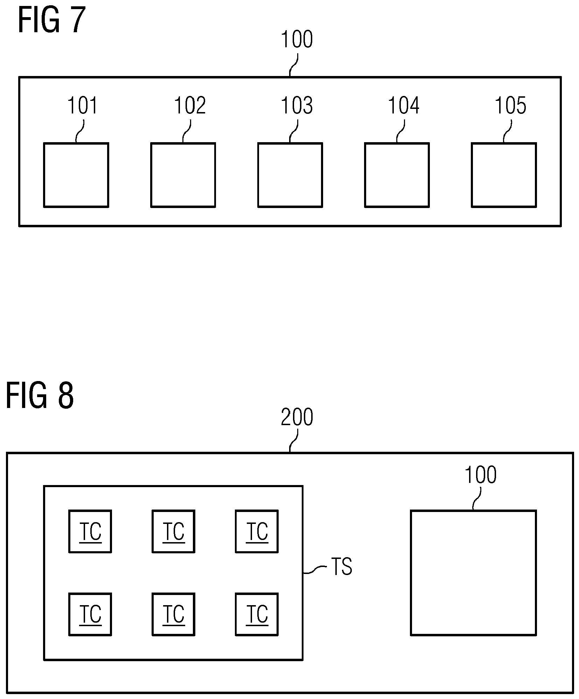

In Fig. 7, a schematic block diagram of a computerized device 100 for testing a technical system TS having a plurality of technical components TC is depicted. The computerized device 100 of Fig. 7 comprises a first providing unit 101, a second providing unit 102, a linking unit 103, a generating unit 104, and a testing unit 105.

The first providing unit 101 is configured to provide a safety model 10 modeling a safety-relevant functionality of the technical system TS.

The second providing unit 102 is configured to provide a test model 30 including test cases C for testing the technical system TS.

The linking unit 103 is configured to link elements of the safety model 10 with elements of the test model 30 for enabling a tracing between the test cases C of the test model 30 and the safety-relevant functionality of the safety model 10.

The generating unit 104 is configured to generate test parameters for at least one certain test case C of the test cases and/or a new test case for the test model 30 using the safety model 10 linked to the test model 30.

The testing unit 105 is configured to test the technical system TS using the certain test case and/or the new test case.

Furthermore, Fig. 8 shows a schematic block diagram of an arrangement 200 comprising a technical system TS and a computerized device 100 for testing the technical system TS.

Although the present invention has been described in accordance with preferred embodiments, it is obvious for the person skilled in the art that modifications are possible in all embodiments.

## Claims

1. A computer-implemented method for testing a technical system (TS) having a plurality of technical components (TC), the method comprising:
a) providing (S1) a safety model (10) modeling a safety relevant functionality of the technical system (TS),
b) providing (S3) a test model (30) including test cases for testing the technical system (TS),
c) linking (S4) elements of the safety model (10) with elements of the test model (30) for enabling a tracing between the test cases (C) of the test model (30) and the safety-relevant functionality of the safety model (10),
d) generating (S5) test parameters for at least one certain test case of the test cases (C) and/or a new test case for the test model (30) using the safety model (10) linked to the test model (30), and
e) testing (S6) the technical system (TS) using the certain test case and/or the new test case.

2. The method of claim 1,
**characterized in**
**that**, in step d) (S4), triggers and parameters of the safety model (10) linked to the test model (30) are analyzed for generating the test parameters for the at least one certain test case (C) and/or the new test case for the test model (30) .

3. The method of claim 1 or 2,
**characterized in**
**that** the test parameters generated in step d) (S4) include preconditions for the at least one certain test case (C), said preconditions defining a relevant context for the safety relevant functionality when operating the technical system (TS), and/or relevant triggers within the certain test case (C) for triggering the safety relevant functionality.

4. The method of one of claims 1 to 3,
**characterized in**
**that**, in step a) (S1), the safety model (10) is provided as a tree of logic, in particular as a component fault tree, such that it includes a top event (TE) associated to a violation of the safety-relevant functionality.

5. The method of claim 4,
**characterized in**
**that**, in step a) (S1), the safety model (10) is provided such that it includes, for each of the technical components (TC) having an input port and/or an output port,
an output failure mode (12) for modeling a certain failure visible at the output port of the technical component (TC), or
an output failure mode (12) for modeling a certain failure visible at the output port of the technical component (TC) and an input failure mode (11) for modeling how a certain failure propagates from the input port to the output port.

6. The method of claim 4,
**characterized in**
**that**, in step a) (S1), the safety model (10) is provided such that it includes, for each of the technical components (TC) having an input port and/or an output port,
an input failure mode (11) for modeling how a certain failure propagates from the input port to the output port,
an output failure mode (12) for modeling a certain failure visible at the output port of the technical component (TC), and/or
a number of basic events (13), each of the basic events (13) modeling an internal component failure of the technical component (TC).

7. The method of claim 6,
**characterized in**
**that** the safety model (10) includes a number of cut-sets, each of the cut-sets combining a number of basic events (13) and adapted to cause the top event (TE).

8. The method of one of claims 4 to 7,
**characterized in**
**that**, in step c) (S4), the top event (TE) of the safety model (10) is linked with those elements of the test model (30) capturing a functionality that is configured to influence an occurrence of the top event (TE).

9. The method of one of claims 6 to 8,
**characterized in**
**that**, in step c) (S4), the safety model (10) and the test model are linked such that
a certain input failure mode (11) of the safety model (10) is linked with a certain input interface (31) of the test model (30),
a certain output failure mode (12) of the safety model (10) is linked with a certain output interface (32) of the test model (30),
a certain basic event (13) of the safety model (10) is linked with an internal component state (33) of the test model (30), and/or
the top event (TE) of the safety model (10) is linked with a certain test case (C) of the test cases of the test model (30) .

10. The method of one of claims 1 to 9,
**characterized by**
providing (S2) a system model (20) modeling a functional behavior of the technical system (TS), in particular a system architecture of the technical system, wherein in step c) (S4), the safety model (10) and the test model (30) are linked via the system model (20),
wherein a certain input failure mode (11) of the safety model (10) is linked with a certain input interface (31) of the test model (30) via a certain input port (21) of the system model (20),
a certain output failure mode (12) of the safety model (10) is linked with a certain output interface (32) of the test model (30) via an output port (22) of the system model (20),
a certain basic event (13) of the safety model (10) is linked with a certain internal component state (33) of the test model (30) via an internal component failure (23) of the system model (20), and/or
the top event (TE) of the safety model (10) is linked with a test case (C) of the test model (30) via a system function (SF) of the system model (20).

11. The method of one of claims 1 to 10,
**characterized by**
analyzing the testing for providing coverage criteria for the safety-relevant functionality.

12. The method of claim 11,
**characterized in**
**that** the coverage criteria are provided such that they include probabilistic criteria for each respective test case (C) of the test cases used in step d) (S5), said probabilistic criteria indicating a probability of occurrence during operation of the technical system (TS), wherein the probability of occurrence is derived by a probability of the cut-set corresponding to the respective test case (C) via the linking of the test model (30) and the safety model (10), that the coverage criteria are provided such that they include qualitative criteria for each respective test case of the test cases (C) used in step e) (S6), the qualitative criteria being derived from the number of basic events (13) of the cut-set corresponding to the respective test case via the linking of the test model (30) and the safety model (10), and/or
the coverage criteria are provided such that they include criteria of occurrence and/or of probability of occurrence for minimal cut-sets corresponding to the test cases used in step e).

13. A computer program product comprising a program code for executing the method of one of claims 1 to 12 for testing a technical system (TS) having a plurality of technical components (TC) when run on at least one computer.

14. A computerized device (100) for testing a technical system (TS) having a plurality of technical components (TC), the computerized device (100) comprising:
a first providing unit (101) for providing a safety model (10) modeling a safety relevant functionality of the technical system (TS),
a second providing (102) unit for providing a test model (30) including test cases (C) for testing the technical system (TS),
a linking unit (103) for linking elements of the safety model (10) with elements of the test model (30) for enabling a tracing between the test cases (C) of the test model (30) and the safety-relevant functionality of the safety model (10),
a generating unit (104) for generating test parameters for at least one certain test case (C) of the test cases and/or a new test case for the test model (30) using the safety model (10) linked to the test model (30), and
a testing unit (105) for testing the technical system (TS) using the certain test case and/or the new test case.

15. An arrangement (200) comprising a technical system (TS) having a plurality of technical components (TC) and a computerized device (100) for testing the technical system (TS) according to claim 14.
